# EUROPEAN PATENT APPLICATION

(11) **EP 4 574 555 A1**
(43) Date of publication of application: **25.06.2025**
(21) Application number: 24852055.3
(22) Date of filing: 27.06.2024
(51) Int. Cl.: B60L 58/18, B60R 16/023, H04W 84/20, B60L 3/12, H03H 7/38

(54) **BATTERY SYSTEM**

(30) Priority: 08.08.2023 KR 20230103594
(71) Applicant: LG Energy Solution, Ltd., Seoul 07335 (KR)
(72) Inventor: YU, Jae Wook, Daejeon 34122 (KR)
(74) Representative: Hoffmann Eitle
(86) International application number: PCT/KR2024/008973
(87) International publication number: WO 2025/033699

(57) **Abstract**

A battery system may include at least one battery module including a battery cell configuration unit and a slave battery management system (BMS) managing the battery cell configuration unit includes a communication unit of the slave BMS, a capacitor connected between the communication unit and a first ground, a first inductor and a second inductor connected in series between a contact between the first ground and the capacitor and a second ground, and a control unit transmitting an AC signal having a predetermined frequency to the communication unit in an antenna mode in which the slave BMS communicates with an outside. In addition, the second inductor may be configured of a wire so that a first antenna impedance determined by the first inductor matches a second antenna impedance of a master BMS that is a communication target.

## Description

### [Technical Field]

### CROSS-REFERENCE TO RELATED APPLICATION

This application claims priority to and the benefit of Korean Patent Application No. 10-2023-0103594 filed in the Korean Intellectual Property Office on August 08, 2023, the entire contents of which are incorporated herein by reference.

The present disclosure relates to a battery system capable of wireless communication between a plurality of battery management systems (BMSs).

### [Background Art]

A battery system applied to an electric vehicle, etc., may include a plurality of battery modules including a battery cell configuration unit and a slave battery management system (BMS) that manages the battery cell configuration unit. In addition, the battery system may further include a master battery management system (BMS) that communicates with a vehicle system and manages the plurality of battery modules.

Recently, research and development on a method for wireless communication between a master BMS and a plurality of slave BMSs has been increasing in order to solve problems, such as poor quality of electrical wirings related to wire cables and connectors and frequent maintenance problems, and to increase a driving range by reducing a weight of an electric vehicle.

### [Disclosure]

### [Technical Problem]

The present disclosure attempts to provide a battery system capable of wireless communication between a plurality of battery management systems (BMSs) without adding separate components for wireless communication.

The present disclosure provides a battery system capable of impedance matching of an antenna with a simple configuration.

The present disclosure provides a battery system capable of wireless communication between a plurality of battery management systems (BMSs) in various industrial scientific and medical bands (ISM bands).

### [Technical Solution]

According to an aspect of the present disclosure, a battery system may include at least one battery module including a battery cell configuration unit and a slave battery management system (BMS) managing the battery cell configuration unit. The battery system may further include a communication unit of the slave BMS, a capacitor connected between the communication unit and a first ground, a first inductor and a second inductor connected in series between a contact between the first ground and the capacitor and a second ground, and a control unit configured to transmit an alternating current (AC) signal having a predetermined frequency to the communication unit in an antenna mode in which the slave BMS communicates with an outside, in which the second inductor is configured to include a wire so that a first antenna impedance determined by the first inductor matches a second antenna impedance of a master BMS that is a communication target.

For the second inductor, at least one of a number of wires, a thickness of the wire, a length of the wire, and a spacing between adjacent wires may be determined so that the first antenna impedance and the second antenna impedance are matched.

The first inductor and second inductor may be located between the battery cell configuration unit and the slave BMS.

A length between the second inductor, which is located farther away from the contact than the first inductor, and the first ground may correspond to approximately 1/4 of a wavelength of the AC signal.

The first ground may be a signal ground of the slave BMS, and the second ground may be a chassis ground of the battery cell configuration unit.

The battery system may further include a monitoring unit electrically connected to each of a plurality of battery cells included in the battery cell configuration unit, and configured to collect battery data including at least one of a current, a voltage, and a temperature of each of the plurality of battery cells.

The control unit may transmit a DC signal to the communication unit in a monitoring mode in which the monitoring unit collects the battery data.

The battery system may further include the master BMS that manages the slave BMS by wirelessly communicating with the communication unit.

The control unit may transmit the collected battery data to the master BMS through the communication unit in the antenna mode.

The first inductor may be configured in a form of a chip having a preset impedance value.

### [Advantageous Effects]

According to the present disclosure, since the wireless communication and impedance matching of antennas can be achieved with a simple configuration, it is possible to reduce the size of the printed circuit board (PCB) constituting the slave BMS and reduce the cost.

According to the present disclosure, since the BMS PCB does not need to be changed according to the frequency band, it is possible to implement the commonization design of the BMS PCB.

### [Description of the Drawings]

FIG. 1 is a block diagram for describing a battery system according to an embodiment.
FIG. 2 is a block diagram illustrating in detail a battery module of FIG. 1.
FIG. 3 is a block diagram illustrating in detail the battery module of FIG. 1 when it operates in a monitoring mode.
FIG. 4 is a block diagram illustrating in detail the battery module of FIG. 1 when it operates in an antenna mode.
FIG. 5 is a block diagram for describing in detail an antenna of FIG. 4.
FIG. 6 is an example of a Smith chart for describing antenna matching according to an embodiment.

### [Mode for Invention]

Hereafter, embodiments of the present disclosure will be described in detail with reference to the accompanying drawings and the same or similar components are given the same reference numerals and are not repeatedly described. The suffix "module" and/or "unit" for components used in the following description is given or mixed in consideration of only the ease of writing of the specification, and therefore, do not have meanings or roles that distinguish from each other in themselves. In addition, when it is determined that a detailed description for known technologies related to the present specification in describing embodiments disclosed in the present specification may unnecessarily obscure the gist of embodiments disclosed in the present specification, the detailed description will be omitted. Further, it should be understood that the accompanying drawings are provided only in order to allow embodiments of the present disclosure to be easily understood, and the spirit of the present disclosure is not limited by the accompanying drawings, but includes all the modifications, equivalents, and substitutions included in the spirit and the scope of the present disclosure.

Terms including an ordinal number such as first, second, etc., may be used to describe various components, but the components are not limited to these terms. The above terms are used solely for the purpose of distinguishing one component from another.

In the present specification, it is to be understood that when one component is referred to as being "connected to" or "coupled to" another component, it may be connected or coupled directly to another component or be connected to another component with the other component interposed therebetween. On the other hand, it should be understood that when one element is referred to as being "connected directly to" or "coupled directly to" another element, it may be connected to or coupled to another element without the other element interposed therebetween.

It will be further understood that terms "include" or "have" used in the present specification specify the presence of features, numerals, steps, operations, components, parts mentioned in the present specification, or combinations thereof, but do not preclude the presence or addition of one or more other features, numerals, steps, operations, components, parts, or combinations thereof.

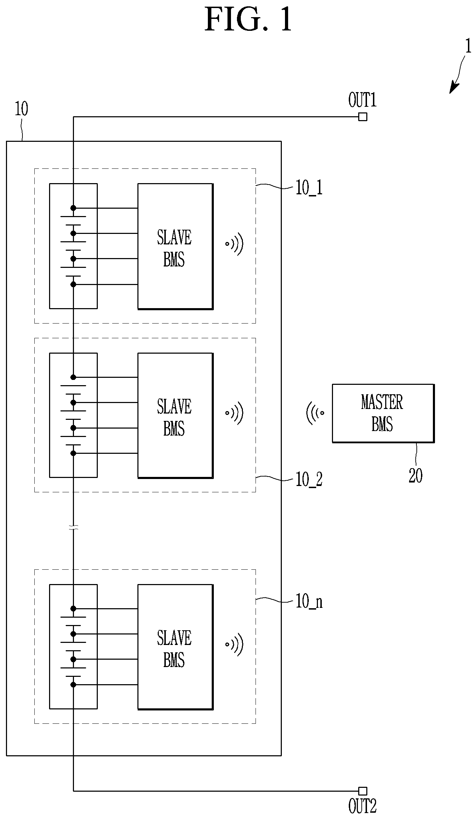

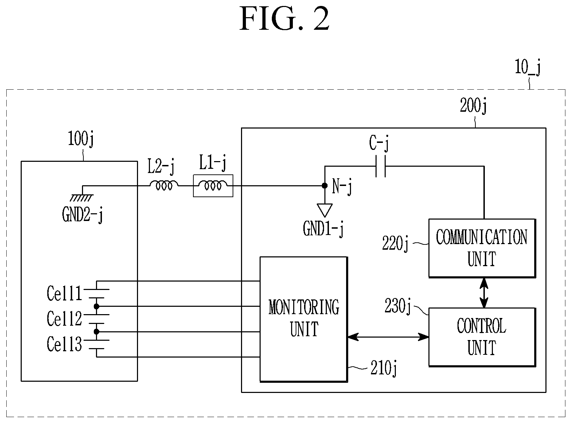

FIG. 1 is a block diagram for describing a battery system according to an embodiment. FIG. 2 is a block diagram illustrating in detail a battery module of FIG. 1.

Referring to FIG. 1, a battery system 1 includes a battery 10 and a master battery management system (hereinafter referred to as a master BMS) 20.

The battery 10 includes at least one battery module. In FIG. 1, a plurality of battery modules 10_1 to 10_n are illustrated, but are not limited thereto, and the battery 10 may include one battery module 10_1.

Hereinafter, when indicating a specific battery module among the plurality of battery modules 10_1 to 10_n, the reference number "10_j" is used, and a battery cell configuration unit and a slave BMS included in the corresponding battery module 10_j use reference numbers "100j" and "200j", respectively. In addition, a capacitor, an inductor, a contact, and an antenna included in the battery module 10_j to be described below are each indicated by reference numbers "Cj", "Lj", "Nj", "200_Aj" .

The battery module 10_j includes the battery cell configuration unit 100j and the slave BMS 200j.

The battery cell configuration unit 100 may include a plurality of battery cells connected in series and/or in parallel. In some embodiments, the battery cell may be a rechargeable secondary battery. In FIGS. 1 and 2, the battery cell configuration unit 100j including three battery cells Cell1, Cell2, and Cell3 connected in series is illustrated, but is not limited thereto. The battery cell configuration unit 100j may include various battery cells.

The slave BMS 200j may collect battery data for the battery cell configuration unit 100j and transmit the collected battery data to the master BMS 20 via wireless communication. In this case, the battery data may include at least one of a cell voltage, a cell current, and a cell temperature of each of the plurality of battery cells Cell1, Cell2, and Cell3. In addition, the battery data may include at least one of the module voltage, which is a voltage across the battery cell configuration unit 100j, and the module current, which is the current flowing through the battery cell configuration unit 100j.

Referring to FIG. 2, the slave BMS 200j may include a monitoring unit 210j, a communication unit 220j, a control unit 230j, a capacitor C-j, a first inductor L1-j, and a second inductor L2-j.

The monitoring unit 210j is electrically connected to the plurality of battery cells Cell1, Cell2, and Cell3 and collects the battery data. For example, the monitoring unit 210j may be composed of an application specific IC (ASIC), a battery monitoring IC (BMIC), etc., as an integrated circuit (IC) capable of collecting the battery data.

Referring to FIG. 2, for example, the monitoring unit 210j is electrically connected to positive and negative electrodes of each of the plurality of battery cells Cell1, Cell2, and Cell3 and measures the cell voltage of each of the plurality of battery cells Cell1, Cell2, and Cell3. For another example, the monitoring unit 210j may receive information on the cell current and cell temperature measured by each of the current sensors and the temperature sensors. For another example, the monitoring unit 210j may measure the cell voltage of each of the plurality of battery cells Cell1, Cell2, and Cell3 at a predetermined cycle during a rest period in which no charging or discharging occurs, and calculate the cell current based on the measured cell voltage. The monitoring unit 210j may collect the battery data at a predetermined cycle or in real time, and transmit the collected battery data to the control unit 230j.

The communication unit 220j may be an analog signal processing device that processes data that needs to be transmitted. For example, the communication unit 220j may be composed of a radio frequency IC (RFIC), but is not limited thereto.

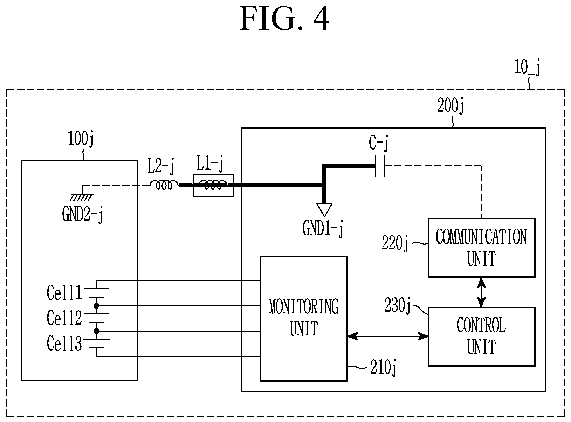

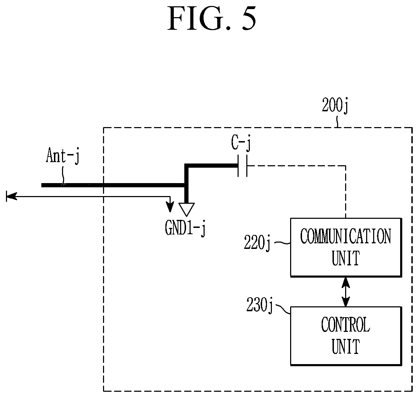

According to an embodiment, the control unit 230j may convert a digital signal into an analog signal (AC signal) and transmit the analog signal (AC signal) to the communication unit 220j. Then, the communication unit 220j amplifies, filters, and processes the analog signal, and transmits the processed analog signal to the antenna. The antenna may convert the processed analog signal into an electromagnetic wave form and transmit the electromagnetic wave into the air. The antenna may be an antenna generated in the antenna mode according to an embodiment, and a detailed description will be described with reference to FIGS. 4 and 5 below.

The control unit 230j may control the overall operation of the slave BMS 200j. For example, the monitoring unit 210j may be controlled to collect the battery data, and the communication unit 220j may be controlled to transmit the collected battery data to the master BMS 20.

The capacitor C-j may be connected between the communication unit 220j and a first ground GND1-j. In this case, the first ground GND1-j may be a signal ground located in the slave BMS 200j, but is not limited thereto. For example, the first ground GND1-j may be implemented as an earth ground or a chassis ground.

The first inductor L1-j and the second inductor L2-j may be connected between a contact N-j between the first ground GND1-j and the capacitor C-j and a second ground GND2-j. For example, when the battery cell configuration unit 100j and the slave BMS 200j are connected with a flexible printed circuit board (FPCB), a first inductor L1-j and a second inductor L2-j may be formed on the FPCB. For another example, when the battery cell configuration unit 100j and the slave BMS 200j are connected with wiring, the first inductor L1-j and the second inductor L2-j may be formed on the wiring.

According to an embodiment, referring to FIG. 2, the first inductor L1-j and the second inductor L2-j may be located in an external space between the battery cell configuration unit 100j and the slave BMS 200j. Specifically, the other end of the first inductor L1-j connected to the contact N-j may be located outside a housing of the slave BMS 200j. In addition, one end of the second inductor L2-j connected to the second ground GND2-j may be located outside the housing of the battery cell configuration unit 100j. In this case, the second ground GND2-j may be the chassis ground located in the battery cell configuration unit 100j, but is not limited thereto. For example, the second ground GND2-j may be implemented as an earth ground or a signal ground.

The first inductor L1-j may be configured in a form of a chip having a preset impedance value. For example, the first inductor L1-j may be mounted on the FPCB connecting the battery cell configuration unit 100j and the slave BMS 200j by a surface mount technology (SMT). The surface mount technology (SMT) is a technology that prints solder paste on the FPCB substrate and mounts chip components thereon using a reflow to bond the FPCB and the chip components.

According to an embodiment, the first inductor L1-j configured in the form of the chip may be standardized at a predetermined size interval, such as 30H, 50H, or 100H. That is, the first inductor L1-j may have a large inductance, but may have a limitation in that it is difficult to precisely tune the impedance.

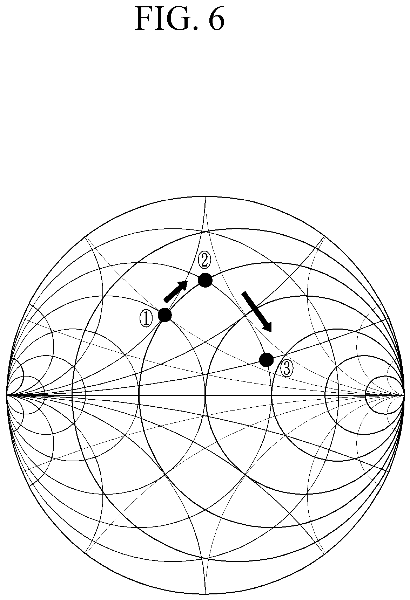

The second inductor L2-j may be configured of a wire. According to an embodiment, the second inductor L2-j may be small in size but is capable of precise impedance tuning. For example, when the number of wires constituting the second inductor L2-j increases, the sizes of the inductance L and the resistance R may decrease. In addition, when the thickness of the wire constituting the second inductor L2-j increases, the size of the resistance R may decrease. In addition, when the material of the wire constituting the second inductor L2-j changes, the values of the inductance L and the resistance R may change depending on the characteristics of the material. In addition, when the length of the wire constituting the second inductor L2-j increases, a size of the inductance L may increase. In addition, when a separation distance between the plurality of wires constituting the second inductor L2-j increases, a value of the capacitance C may increase. A specific method of tuning the impedance by changing the number, thickness, material, and length of wires constituting the second inductor L2-j is described below together with FIG. 6.

The master BMS 20 may wirelessly communicate with each of the plurality of slave BMSs to transmit various control signals or receive the battery data. The slave BMS 200j according to the embodiment may wirelessly communicate with the master BMS 20 without including a separate antenna device. This will be described in detail with reference to FIGS. 4 and 5 below.

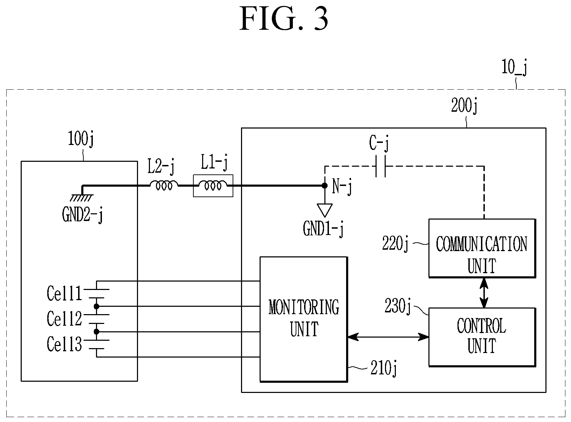

FIG. 3 is a block diagram illustrating in detail the battery module of FIG. 1 when it operates in a monitoring mode. FIG. 4 is a block diagram illustrating in detail the battery module of FIG. 1 when it operates in an antenna mode. FIG. 5 is a block diagram for describing in detail an antenna of FIG. 4.

According to the embodiment, the battery module 10_j may operate in the monitoring mode for collecting the battery data and the antenna mode for communicating with the outside. Hereinafter, FIG. 3 describes in detail the structure of the battery module 10_j in the monitoring mode, and FIGS. 4 and 5 describe in detail the structure of the battery module 10_j in the antenna mode.

Referring to FIG. 3, in the monitoring mode, the control unit 230j may control the communication unit 220j to transmit a direct current (DC) signal to the capacitor C-j.

When the DC signal is applied to the capacitor C-j, a circuit as illustrated in FIG. 3 may be formed according to the electrical characteristics of the capacitor C-j that opens by the DC signal. That is, the other end of the first inductor L1-j may be connected to the first ground GND1-j, and one end of the second inductor L2-j may be connected to the second ground GND2-j. In this case, external noise may be removed by the first inductor L1-j and the second inductor L2-j.

Referring to FIG. 4, in the antenna mode, the control unit 230j may control the communication unit 220j to transmit an alternating current (AC) signal having a predetermined frequency to the capacitor C-j.

When the AC signal is applied to the capacitor C-j, a circuit as illustrated in FIG. 4 may be formed according to the electrical characteristics of the first inductor L1-j and the second inductor L2-j that open by the AC signal.

Even if the AC signal passes through the first inductor L1-j, the area after the first inductor L1-j does not completely open, and some of the AC signal remains. Then, when the AC signal passes through the second inductor L2-j, almost no AC signal remains. In FIG. 5, the darker the color, the stronger the RF AC signal component may be, and the second inductor L2-j may also serve as an antenna.

Specifically, a transmission line (bolded portion) connecting among a first terminal connected to the capacitor C-j, a second terminal connected to the first ground GND1-j, and a third terminal adjacent to the second inductor L2-j may perform an inverted-F antenna function. That is, in the antenna mode for communicating with the outside (e.g., master BMS), an antenna Aj corresponding to the inverted-F antenna structure may be formed in the slave BMS 200j.

The inverted F antenna is an antenna formed to improve impedance matching of an inverted-L antenna. In this case, the inverted-L antenna may be an antenna formed by horizontally bending about 80% of an upper length of a monopole antenna to reduce its height.

Referring to FIG. 4, for example, an antenna Ant-j may convert an AC signal input through the communication unit 220j into an electromagnetic wave and transmit the converted electromagnetic wave into the air. As another example, the antenna Aj may receive an electromagnetic wave, convert the received electromagnetic wave into the AC signal, and transmit the converted AC signal to the communication unit 220j.

According to an embodiment, the antenna Ant-j may resonate at a frequency having a wavelength λ four times an antenna length AL. Specifically, the inverted F antenna may be configured to have an antenna length (AL = λ/4) corresponding to 1/4 of the wavelength λ of the signal to be transmitted and received. In this case, the antenna length may correspond to the length AL-j between the second inductor L2-j and the first ground GND1-j.

For example, in order to transmit and receive a signal corresponding to a frequency of 2.45 GHZ, the antenna length AL may be configured to be 30.61 mm. In another example, in order to transmit and receive a signal corresponding to a frequency of 915 MHZ, the antenna length AL may be configured to be 81.97 mm.

According to an embodiment, the antenna length AL-j may be determined according to positions (mounting distances) of the first inductor L1-j and the second inductor L2-j. That is, by a simple operation of changing the positions where the first inductor L1-j and the second inductor L2-j are mounted, the slave BMS 200j may wirelessly communicate with the master BMS 20 in various industrial scientific and medical (ISM) frequency bands.

FIG. 6 is an example of a Smith chart for describing antenna matching according to an embodiment.

In the antenna system, if the impedance mismatch occurs, a reflected wave may be generated, resulting in power loss. That is, when connecting two circuits, such as a signal source and a load, it is necessary to achieve the impedance matching so that there is no reflection loss. The impedance matching of sensitive receiver components can improve a signal-to-noise ratio (SNR) and linearize frequency characteristics.

According to an embodiment, in the wireless communication between the slave BMS 200j and the master BMS 20, one side may be a signal source and the other side may be a load. Hereinafter, for convenience of description, the impedance matching that matches the impedance of the slave BMS 200j to the impedance of the master BMS 20 is described below. That is, the impedance of the slave BMS 200j is referred to as a load impedance, and the impedance of the master BMS 20 is referred to as a signal source impedance.

Fig. 6 is an example of a Smith chart, and the Smith chart may be in the form of an impedance chart and an admittance chart overlapping each other. Since the impedance chart and the admittance chart are each widely known in the past, drawing and description are omitted. According to an embodiment, the impedance matching may be described using the Smith chart.

According to an embodiment, when the second inductor L2-j varies for the impedance matching using the Smith chart, if the inductance component increases, it moves along an upward direction of the concentric circle of the Smith chart, and if the capacitance component increases, it moves along a downward direction of the concentric circle of the Smith chart.

In a state where only the first inductor L1-j in the form of a standardized chip is mounted, an impedance mismatch, i.e., a deviation, may occur between the master BMS 20 and the slave BMS 200j. For example, in FIG. 6, it is assumed that a first coordinate (①) is a load impedance corresponding to the slave BMS 200j in a state where only the first inductor L1-j is mounted, and a third coordinate (③) is the signal source impedance corresponding to the master BMS 20. In order to match the first coordinate (①) with the third coordinate (③), at least one of the number of wires constituting the second inductor L2-j, the thickness of the wire, the length of the wire, and the spacing between adjacent wires may be determined.

For example, when the number of wires constituting the second inductor L2-j increases, the sizes of the inductance L and the resistance R may decrease. In addition, when the thickness of the wire constituting the second inductor L2-j increases, the size of the resistance R may decrease. In addition, when the material of the wire constituting the second inductor L2-j changes, values of the inductance L and the resistance R may change depending on the characteristics of the material. In addition, when a length of the wire constituting the second inductor L2-j increases, a size of the inductance L may increase. In addition, when a separation distance between the plurality of wires constituting the second inductor L2-j increases, a value of the capacitance C may increase.

According to an embodiment, the impedance matching may be realized by performing the impedance tuning using the second inductor L2-j after mounting the first inductor L1-j. To move the first coordinate (①) to the third coordinate (③) that is a target point, which trajectory of the Smith chart is selected may be variously selected by the user. For example, in FIG. 6, it is assumed that after moving from the first coordinate (①) to the second coordinate (②), the second coordinate (②) is moved to the third coordinate (③) that is the target coordinate.

Referring to FIG. 6, in order to move from the first coordinate (①) to the second coordinate (②), it is necessary to move in the upward direction of the concentric circle in the Smith chart, so the increase in the inductance component is required. For example, as described above, the length of the wire constituting the second inductor L2-j may increase to greatly increase the inductance component. In order to move from the second coordinate (②) to the third coordinate (③), it is necessary to move in the downward direction of the concentric circle on the Smith chart, so the increase in the capacitance component is required. For example, as described above, the separation distance of the wire constituting the second inductor L2-j may increase to greatly increase the capacitance component. However, it is not limited to this example, and the number of wires constituting the second inductor L2-j, the thickness of the wires, the length of the wire, and the spacing between adjacent wires may comprehensively change to match the first coordinate (①) with the third coordinate (③).

Although the embodiments of the present invention have been described in detail above, the scope of the present invention is not limited thereto, and various modifications and improvements by those of ordinary skill in the field to which the present invention pertains belong to the scope of the present invention.

## Claims

1. A battery system including at least one battery module including a battery cell configuration unit and a slave battery management system (BMS) managing the battery cell configuration unit, the battery system comprising:
a communication unit of the slave BMS;
a capacitor connected between the communication unit and a first ground;
a first inductor and a second inductor connected in series between a contact between the first ground and the capacitor and a second ground; and
a control unit configured to transmit an alternating current (AC) signal having a predetermined frequency to the communication unit in an antenna mode in which the slave BMS communicates with an outside,
wherein the second inductor is configured to include a wire so that a first antenna impedance determined by the first inductor matches a second antenna impedance of a master BMS that is a communication target.

2. The battery system of claim 1, wherein:
for the second inductor, at least one of a number of wires, a thickness of the wire, a length of the wire, and a spacing between adjacent wires is determined so that the first antenna impedance and the second antenna impedance are matched.

3. The battery system of claim 2, wherein:
the first inductor and second inductor are located between the battery cell configuration unit and the slave BMS.

4. The battery system of claim 3, wherein:
a length between the second inductor, which is located farther away from the contact than the first inductor, and the first ground corresponds to approximately 1/4 of a wavelength of the AC signal.

5. The battery system of claim 1, wherein:
the first ground is a signal ground of the slave BMS, and
the second ground is a chassis ground of the battery cell configuration unit.

6. The battery system of claim 5, further comprising:
a monitoring unit electrically connected to each of a plurality of battery cells included in the battery cell configuration unit, and configured to collect battery data including at least one of a current, a voltage, and a temperature of each of the plurality of battery cells.

7. The battery system of claim 6, wherein:
the control unit transmits a direct current (DC) signal to the communication unit in a monitoring mode in which the monitoring unit collects the battery data.

8. The battery system of claim 7, further comprising:
the master BMS that manages the slave BMS by wirelessly communicating with the communication unit.

9. The battery system of claim 8, wherein:
the control unit transmits the collected battery data to the master BMS through the communication unit in the antenna mode.

10. The battery system of claim 1, wherein:
the first inductor is configured in a form of a chip having a preset impedance value.
